(19) Europäisches Patentamt
European Patent Office
Office européen des brevets

(11) **EP 3 510 640 B1**

(12) **FASCICULE DE BREVET EUROPEEN**

(45) Date de publication et mention
de la délivrance du brevet:
**05.08.2020 Bulletin 2020/32**

(21) Numéro de dépôt: **17771815.2**

(22) Date de dépôt: **07.09.2017**

(51) Int Cl.:
*H01L 31/18* $^{(2006.01)}$    *C30B 29/06* $^{(2006.01)}$

(86) Numéro de dépôt international:
**PCT/FR2017/052375**

(87) Numéro de publication internationale:
**WO 2018/046855 (15.03.2018 Gazette 2018/11)**

(54) **PROCÉDÉ DE TRI DE PLAQUETTES EN SILICIUM EN FONCTION DE LEUR DURÉE DE VIE VOLUMIQUE**

VERFAHREN ZUM SORTIEREN VON SILICIUMWAFERN NACH IHRER VOLUMENLEBENSDAUER

METHOD FOR SORTING SILICON WAFERS ACCORDING TO THEIR BULK LIFETIME

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **08.09.2016 FR 1658368**

(43) Date de publication de la demande:
**17.07.2019 Bulletin 2019/29**

(73) Titulaire: **Commissariat à l'Énergie Atomique et aux Énergies Alternatives
75015 Paris (FR)**

(72) Inventeurs:
• **LETTY, Elénore
38300 Bourgoin Jallieu (FR)**
• **FAVRE, Wilfried
73000 Chambery (FR)**
• **VEIRMAN, Jordi
73290 La Motte-Servolex (FR)**

(74) Mandataire: **Cabinet Camus Lebkiri
25 rue de Maubeuge
75009 Paris (FR)**

(56) Documents cités:
**FR-A1- 2 964 459**

• **JORDI VEIRMAN ET AL: "A Fast and Easily Implemented Method for Interstitial Oxygen Concentration Mapping Through the Activation of Thermal Donors in Silicon", ENERGY PROCEDIA, vol. 8, 17 avril 2011 (2011-04-17), - 20 avril 2011 (2011-04-20), pages 41-46, XP028263041, ISSN: 1876-6102, DOI: 10.1016/J.EGYPRO.2011.06.099 [extrait le 2011-08-12]**

EP 3 510 640 B1

**Description**

**DOMAINE TECHNIQUE**

La présente invention concerne un procédé de tri de plaquettes en silicium, mis en œuvre après leur découpage dans un lingot et avant qu'elles ne soient utilisées pour la fabrication de dispositifs semi-conducteurs, tels que des cellules photovoltaïques.

**ÉTAT DE LA TECHNIQUE**

Environ 10 % à 20 % des plaquettes en silicium monocristallin obtenues par le procédé de tirage Czochralski sont incompatibles avec la fabrication de cellules photovoltaïques à haut rendement. En effet, ces plaquettes contiennent des défauts qui limitent la durée de vie des porteurs de charge photogénérés et conduisent à des diminutions de rendement pouvant atteindre 4 % (absolu).

Parmi les défauts qui limitent la durée de vie, on peut citer les donneurs thermiques (DT). Les donneurs thermiques sont des agglomérats créés à partir de l'oxygène interstitiel contenu dans le silicium (i.e. les atomes d'oxygène occupent des positions interstitielles dans le réseau cristallin). Ils se forment lors du tirage du lingot, lorsque la température de silicium est comprise entre 350 °C et 500 °C.

Les plaquettes dont la concentration en donneurs thermiques est la plus élevée et dont le rendement risque par conséquent d'être limité sont généralement situées dans la partie haute du lingot, appelée également tête du lingot. Cela s'explique d'une part par le fait que la partie haute du lingot (i.e. la partie du lingot cristallisée en premier) contient une plus grande quantité d'oxygène, et d'autre part, par le fait qu'elle subit un refroidissement plus lent que la partie basse du lingot (cristallisée en dernier). En effet, elle reste en contact thermique avec le bain de silicium fondu pendant toute la durée du tirage. La durée pendant laquelle la température du silicium se situe dans la plage de formation des donneurs thermiques (350 °C-500 °C) est donc plus importante pour la partie haute du lingot que pour sa partie basse.

Les donneurs thermiques sont détruits lors d'un traitement thermique à une température supérieure ou égale à 600 °C. Les cellules photovoltaïques à homojonction, dont le procédé de fabrication fait appel à de tels traitements thermiques, ne contiennent donc (quasiment) plus de donneurs thermiques et leur rendement n'est pas diminué. Par contre, les procédés de fabrication de cellules photovoltaïques à basse température (<250 °C), tel que le procédé de fabrication de cellules à hétérojonction en silicium (amorphe/cristallin), ne permettent pas de supprimer les donneurs thermiques. Ces donneurs thermiques affecteront les performances des cellules à hétérojonction en réduisant la durée de vie volumique des porteurs.

Il n'existe à l'heure actuelle aucune solution pour déterminer a priori, c'est-à-dire en entrée d'une ligne de production de cellules lorsque les plaquettes sont dans un état brut de découpe (« as-cut state » en anglais), quel sera l'impact des donneurs thermiques présents dans les plaquettes sur les performances futures des cellules photovoltaïques à hétérojonction. Une telle information permettrait d'écarter les plaquettes de mauvaise qualité avant qu'elles n'entament le procédé de fabrication de cellules, réalisant ainsi d'importantes économies.

Le document [« Quality Control of Czochralski Grown Silicon Wafers in Solar Cell Production Using Photoluminescence Imaging », J. Haunschild et al., 26th European PV Solar Energy Conférence and Exhibition, 5-9 September 2011, Hamburg] propose une méthode de tri de plaquettes destinées à la fabrication de cellules photovoltaïques à homojonction, sur la base d'images de photoluminescence des plaquettes. Les images de photoluminescence (utilisées pour effectuer le tri) sont prises après que les plaquettes aient subi une étape de diffusion d'émetteur à haute température. Les plaquettes ne sont donc plus dans l'état brut de découpe. Lorsque l'image de photoluminescence d'une plaquette montre un ou plusieurs cercles noirs (i.e. un signal de photoluminescence faible), cela signifie que le rendement de la cellule photovoltaïque finie sera faible à cause de la présence de précipités d'oxygène. Cette plaquette peut donc être écartée.

Ces précipités d'oxygène sont des défauts liés à l'oxygène, différents des donneurs thermiques, et ne peuvent être différenciés des donneurs thermiques sur une image de photoluminescence qu'après avoir détruit les donneurs thermiques présents initialement dans les plaquettes (d'où la nécessité d'avoir recours à l'étape de diffusion à haute température). En effet, les images de photoluminescence de plaquettes contenant des fortes concentrations en donneurs thermiques montrent systématiquement des cercles noirs, rendant impossible la différenciation entre les plaquettes de haut rendement et les plaquettes de faible rendement (après fabrication des cellules à homojonction).

Cette méthode de tri n'est donc pas applicable à des plaquettes de silicium dans l'état brut de découpe, en raison de la présence des donneurs thermiques. De façon plus générale, le document susmentionné ne s'intéresse aucunement à l'influence des donneurs thermiques sur les performances d'une cellule photovoltaïque à hétérojonction. Il concerne la fabrication de cellules photovoltaïques à homojonction, au cours de laquelle les donneurs thermiques sont détruits (ils sont qualifiés d'inoffensifs dans le document).

En outre, cette méthode de tri des plaquettes ne permet pas d'optimiser au maximum la fabrication de cellules à homojonction, car elle requiert d'accomplir systématiquement la première étape du procédé de fabrication : la diffusion de l'émetteur (par exemple 10 s à 800 °C). Cette étape représente une dépense inutile lorsque les plaquettes sont finalement écartées.

FR2964459 décrit un procédé de détermination de la concentration en donneurs thermiques de plaquettes en silicium.

## RÉSUMÉ DE L'INVENTION

Il existe donc un besoin de prévoir un procédé de tri de plaquettes en silicium monocristallin de type Czochralski, permettant d'écarter à moindre coût des plaquettes de mauvaise qualité. Une plaquette est dite de mauvaise qualité lorsque les performances du dispositif (ou des dispositifs) semi-conducteur(s) formé(s) sur cette plaquette sont faibles.

Selon l'invention, on tend à satisfaire ce besoin en prévoyant un procédé de tri de plaquettes, mis en œuvre lorsque les plaquettes sont dans un état brut de découpe ou dans un état de mise en forme de leur surface, ce procédé comprenant les étapes suivantes :

a) mesurer la concentration en porteurs de charge libres majoritaires dans une zone au moins de chaque plaquette ;
b) calculer la concentration en donneurs thermiques dans ladite zone de chaque plaquette, à partir de la concentration en porteurs de charge libres ;
c) calculer la durée de vie des porteurs de charge limitée par les donneurs thermiques dans ladite zone de chaque plaquette, à partir de la concentration en donneurs thermiques ;
d) déterminer une valeur de durée de vie volumique des porteurs de charge dans chaque plaquette, à partir de la durée de vie limitée par les donneurs thermiques ;
e) comparer la valeur de durée de vie volumique ou une valeur normalisée de la durée de vie volumique à une valeur seuil ; et
f) écarter la plaquette lorsque la valeur de durée de vie volumique ou la valeur normalisée de la durée de vie volumique est inférieure à la valeur seuil.

L'état « brut de découpe » désigne l'état dans lequel le fabricant de lingots fournit les plaquettes de silicium aux fabricants de dispositifs semi-conducteurs. À ce stade, les plaquettes n'ont subi encore aucune étape d'un quelconque procédé de fabrication de dispositifs semi-conducteurs. Plus particulièrement, elles n'ont subi aucune étape susceptible de modifier la réflectivité de la plaquette (ex. étape de texturation), de modifier la durée de vie volumique ou surfacique des porteurs de charge (ex. étape de passivation), de modifier la concentration en porteurs de charge (ex. dopage) ou la concentration en donneurs thermiques (ex. recuit). Éventuellement, les plaquettes peuvent avoir fait l'objet d'un nettoyage, afin d'enlever des résidus de découpe (ex. poussière), mais sans modification de leur surface.

Les plaquettes se trouvent dans l'état dit « de mise en forme de leur surface » après que les plaquettes brutes de découpe aient subi une étape de mise en forme de leur surface, telle qu'une étape de texturation ou une étape de polissage mécanique et/ou chimique.

Le procédé selon l'invention effectue un tri de plaquettes sur la base d'au moins une valeur de la durée de vie limitée par les donneurs thermiques. Par « durée de vie limitée par les donneurs thermiques », on désigne la contribution des donneurs thermiques sur la durée de vie volumique des porteurs de charge dans une plaquette. La durée de vie limitée par les donneurs thermiques est égale à la durée de vie qu'auraient les porteurs de charge si les donneurs thermiques étaient les seuls défauts recombinants (i.e. limitant la durée de vie) présents dans le silicium et en négligeant les mécanismes de recombinaison intrinsèques. Elle donne un aperçu fiable des performances qu'auront le ou les dispositifs semi-conducteurs formés à partir de cette plaquette, par exemple le rendement d'une cellule photovoltaïque à hétérojonction.

Les donneurs thermiques sont en effet parmi les défauts qui peuvent limiter le plus la durée de vie volumique des porteurs de charge. Ainsi, même en ne tenant compte que des donneurs thermiques, on peut effectuer un tri satisfaisant des plaquettes qui sera la source d'importantes économies. Les plaquettes dont la durée de vie volumique est trop faible sont écartées et ne connaitront pas le processus de fabrication des cellules photovoltaïques.

En dehors des étapes de calcul et de comparaison à la valeur seuil, le procédé de tri selon l'invention ne requiert qu'une mesure de la concentration en porteurs de charge libres majoritaires, appelée également dopage net, pour déterminer la concentration en donneurs thermiques, puis calculer la durée de vie limitée par les donneurs thermiques. Il est donc particulièrement simple et économique à mettre en œuvre.

En particulier, il ne fait appel à aucune étape préliminaire, comme la diffusion de l'émetteur dans le procédé de tri de l'art antérieur. Autrement dit, les plaquettes restent dans l'état brut de découpe (ou de mise en forme) tout au long du procédé. L'absence d'étape préliminaire constitue une économie importante par rapport au procédé de tri de l'art antérieur.

La concentration en porteurs de charge libres majoritaires est mesurée dans une zone de chaque plaquette où la concentration en donneurs thermiques est (théoriquement) importante, de préférence dans une zone éloignée des bords de la plaquette d'une distance supérieure à 5 mm, et encore plus préférentiellement dans une zone située au centre de la plaquette. En effet, c'est au centre des plaquettes qu'on observe généralement la plus forte concentration en donneurs thermiques, et donc la durée de vie limitée par les donneurs thermiques la plus faible.

Avantageusement, le procédé de tri comporte en outre une étape de calcul de la durée de vie des porteurs de charge limitée par des mécanismes de recombinaison intrinsèques dans ladite zone de chaque plaquette, la valeur de durée de vie volumique étant en outre déterminée à partir de la durée de vie limitée par les mécanismes de recombinaison intrinsèques. La prise en compte des mécanismes de recombinaison intrinsèques (recombinaisons Auger et recombinaisons radiatives) dans le calcul de la durée de vie volumique (en plus des donneurs thermiques) permet de durcir les conditions de tri, car la valeur de durée de vie à comparer au seuil sera encore plus faible.

Dans un mode de mise en œuvre préférentiel du procédé de tri, la concentration en porteurs de charge libres dans ladite au moins une zone est déterminée à partir d'une mesure de photoluminescence de la plaquette. La photoluminescence est une technique de mesure précise et rapide qui, lorsqu'elle est utilisée en imagerie, permet d'obtenir en une seule fois une multitude de valeurs de concentration en porteurs de charge libres. En outre, les équipements de photoluminescence ont une cadence équivalente à celle d'une ligne de production de cellules photovoltaïques. Le procédé de tri, exécuté en entrée de ligne, ne ralentira donc pas la fabrication des cellules. Lorsque la technique de photoluminescence est utilisée, l'épaisseur des plaquettes est avantageusement inférieure à 580 $\mu$m.

Le procédé selon l'invention peut également présenter une ou plusieurs des caractéristiques ci-dessous, considérées individuellement ou selon toutes les combinaisons techniquement possibles :

- les étapes a) à d) sont mises en œuvre dans plusieurs zones de chaque plaquette, d'où il résulte une pluralité de valeurs de durée de vie volumique pour chaque plaquette, et le procédé comprend en outre une étape de détermination, parmi la pluralité de valeurs de durée de vie volumique, d'une valeur minimale de durée de vie, ladite valeur minimale étant comparée à la valeur seuil à l'étape e) ;

- lorsque les plaquettes contient des dopants, le procédé comprend en outre une étape de mesure de la concentration en dopants de chaque plaquette, la concentration en donneurs thermiques dans ladite zone de chaque plaquette étant calculée à l'étape b) à partir de la concentration en porteurs de charge libres majoritaires et de la concentration en dopants ;

- la concentration en dopants de chaque plaquette est obtenue par une mesure de la concentration en porteurs de charge libres majoritaires dans une zone située au voisinage immédiat d'un bord de la plaquette ;

- la concentration en porteurs de charge libres majoritaires dans la zone située au voisinage immédiat du bord de la plaquette est dérivée d'une mesure de photoluminescence ;

- la valeur normalisée de la durée de vie volumique est calculée à partir de la valeur de durée de vie volumique obtenue à l'étape d) et d'une valeur de résistivité de la plaquette ; et

- les plaquettes sont dopées de type n.

Un autre aspect de l'invention concerne un procédé de tri de plaquettes spécialement adapté aux plaquettes issues de lingots en silicium monocristallin de type Czochralski contenant des dopants de type p, dans lesquelles il existe un risque d'inversion du dopage à cause de la formation des donneurs thermiques.

Ce procédé est également mis en œuvre lorsque les plaquettes sont dans un état brut de découpe ou dans un état de mise en forme de leur surface. Il comprend les étapes suivantes :

- effectuer des mesures d'un paramètre représentatif de la concentration en porteurs de charge libres majoritaires sur chaque plaquette, les mesures étant réparties entre un bord et le centre de la plaquette ;
- déterminer si ledit paramètre diminue de façon continue entre le bord et le centre de chaque plaquette ; et

lorsque ledit paramètre diminue de façon continue, les étapes suivantes :

a) mesurer la concentration en porteurs de charge libres majoritaires dans une zone au moins de la plaquette ;
b) calculer la concentration en donneurs thermiques dans ladite zone de la plaquette, à partir de la concentration en porteurs de charge libres majoritaires ;
c) calculer la durée de vie des porteurs de charge limitée par les donneurs thermiques dans ladite zone de la plaquette, à partir de la concentration en donneurs thermiques ;

d) déterminer une valeur de durée de vie volumique des porteurs de charge dans la plaquette, à partir de la durée de vie limitée par les donneurs thermiques ;

e) comparer la valeur de durée de vie volumique à une première valeur seuil ;

f) écarter la plaquette lorsque la valeur de durée de vie volumique est inférieure à la première valeur seuil ; et

lorsque ledit paramètre ne diminue pas de façon continue, les étapes suivantes :

- déterminer une variation relative dudit paramètre entre le minimum dudit paramètre et une valeur dudit paramètre au centre de la plaquette ;
- comparer la variation relative dudit paramètre à une deuxième valeur seuil ;
- écarter la plaquette lorsque la deuxième variation relative dudit paramètre est supérieure à la deuxième valeur seuil ;
- mettre en œuvre les étapes a) à f) lorsque la variation relative dudit paramètre est inférieure à la deuxième valeur seuil.

## BRÈVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :

- la figure 1 représente schématiquement des étapes S1 à S6 d'un premier procédé de tri selon l'invention ;
- la figure 2 est une courbe de calibration d'un équipement de photoluminescence, permettant de mesurer la concentration en porteurs de charge libres à l'étape S1 de la figure 1 ;

- la figure 3 illustre un mode de mise en œuvre préférentiel de l'étape S1 de la figure 1 ;
- la figure 4 illustre un mode de mise en œuvre préférentiel de l'étape S2 de la figure 1 ;
- la figure 5 illustre un mode de mise en œuvre préférentiel de l'étape S3 de la figure 1 ;
- la figure 6 représente schématiquement des étapes d'un deuxième procédé de tri selon l'invention, spécialement adapté à des plaquettes de silicium contenant des dopants de type p ; et
- les figures 7A et 7B représentent des courbes de l'intensité de photoluminescence pour deux plaquettes de silicium contenant des dopants de type p.

Pour plus de clarté, les éléments identiques ou similaires sont repérés par des signes de référence identiques sur l'ensemble des figures.

## DESCRIPTION DÉTAILLÉE D'AU MOINS UN MODE DE RÉALISATION

Un lingot en silicium monocristallin obtenu par le procédé Czochralski (CZ) contient une importante quantité de donneurs thermiques, car le silicium présente une concentration élevée en oxygène interstitiel et subit un refroidissement lent. Ces donneurs thermiques se retrouvent ensuite dans les plaquettes de silicium issues de la découpe du lingot.

Les donneurs thermiques produisent deux effets sur les propriétés du silicium. Premièrement, ils influent sur la concentration en porteurs de charge libres majoritaires, appelée communément dopage net, car chaque donneur thermique génère deux électrons libres. Deuxièmement, certains donneurs thermiques agissent comme centres de recombinaison des paires électrons-trou, ce qui limite la durée de vie volumique des porteurs de charge.

Les procédés de tri décrits ci-après exploitent ces deux effets pour respectivement déterminer la concentration en donneurs thermiques à partir de la concentration en porteurs de charge libres majoritaires et déterminer la durée de vie limitée par les donneurs thermiques à partir de la concentration en donneurs thermiques. Ces procédés sont mis en œuvre lorsque les plaquettes sont, de préférence, à l'état brut de découpe.

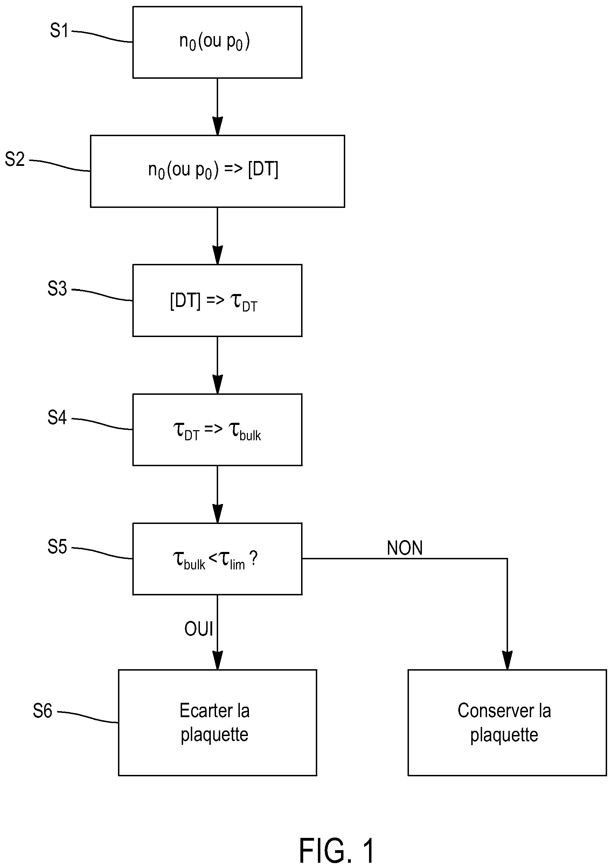

La figure 1 représente schématiquement des étapes S1 à S6 d'un premier procédé de tri de plaquettes en silicium selon l'invention. Ces plaquettes sont par exemple destinées à la fabrication de cellules photovoltaïques. La forme des plaquettes peut être quelconque, par exemple circulaire, carrée ou pseudo-carrée.

L'étape S1 consiste à mesurer la concentration en porteurs de charge libres majoritaires dans une zone au moins de chaque plaquette de silicium à trier. La concentration en porteurs de charge libres majoritaires, notée ci-après no dans le cas d'un silicium dopé de type n (électrons majoritaires) et po dans le cas d'un silicium dopé de type p (trous majoritaires), s'écrit de la façon suivante :

$$n_0 = N_d + 2\,[DT] \qquad (1a)$$

$$p_0 = N_a - 2\,[DT] \qquad (1b)$$

où $N_d$ est la concentration en dopants donneurs (phosphore, arsenic, antimoine...) introduits volontairement dans le silicium, $N_a$ est la concentration en dopants accepteurs (bore, gallium, aluminium...) introduits volontairement dans le silicium, et [DT] est la concentration en donneurs thermiques formés au cours du tirage du lingot.

Différentes techniques peuvent être utilisées pour mesurer la concentration en porteurs de charge libres $n_0/p_0$. Cette concentration peut notamment être dérivée d'une mesure de résistivité électrique (par exemple fournie par la méthode des quatre pointes) ou d'une mesure de réflectivité des micro-ondes (par exemple par la technique de conductivité micro-onde résolue en temps, ou « Time Resolved Microwave Conductivity » en anglais). La technique d'imagerie infrarouge appelée « Carrier Density Imaging » en anglais est également une façon (directe) de mesurer la concentration en porteurs de charge libres $n_0/p_0$.

La zone dans laquelle la concentration en porteurs de charge libres est mesurée est, pour la suite de la description, appelée « zone de mesure ».

À l'étape S2 de la figure 1, la concentration en donneurs thermiques [DT] est déterminée dans la zone de mesure de chaque plaquette à trier, à partir de la concentration en porteurs de charge $n_0/p_0$ correspondante. La concentration en donneurs thermiques [DT] est de préférence calculée en utilisant la relation (1a) ou (1b) ci-dessus.

Lorsque les plaquettes contiennent des dopants accepteurs ou donneurs, par exemple des atomes de bore ou de phosphore, la détermination du la concentration en donneurs thermiques [DT] suppose de connaître la concentration en dopants accepteurs $N_A$ ou donneurs $N_D$ dans chaque plaquette (cf. relations (1a) et (1b)). Lorsque cette concentration en dopants $N_a/N_d$ est inconnue, elle peut être facilement obtenue à partir d'une des valeurs de la concentration en porteurs de charge $n_0/p_0$, mesurée au voisinage immédiat d'un bord de la plaquette, et de préférence dans la zone la plus éloignée du centre de la plaquette.

Les auteurs de l'article [« A New Method for the Détermination of the Dopant-Related Base Resistivity Despite the Presence of Thermal Donors », J. Broisch et al., IEEE Journal of Photovoltaics, Vol.5, No.1, 2015] ont en effet démontré que la concentration en donneurs thermiques [DT] pouvait être considérée comme négligeable aux quatre angles d'une plaquette carrée et que, par conséquent, la résistivité électrique mesurée aux angles étant uniquement due aux dopants introduits volontairement dans le silicium.

Dans le procédé de tri selon l'invention, la concentration en donneurs thermiques [DT] est supposée nulle en un point de la plaquette dès lors qu'il se situe à moins de 5 mm, et préférentiellement à moins de 1 mm, de l'un quelconque des bords de la plaquette, autrement dit dans toute une bande périphérique de la plaquette et pas seulement dans ses angles. La mesure de la concentration en porteurs de charge libres $n_0$ (respectivement $p_0$) en ce point donne alors directement la concentration en dopants donneurs $N_d$ (respectivement accepteurs $N_a$) ($n_0 = N_d$ ou $p_0 = N_a$).

Lorsque les plaquettes ont une forme carrée, la concentration en dopants donneurs $N_d$ (respectivement accepteurs $N_a$) est avantageusement obtenue à partir d'une valeur de la concentration $n_0$ (respectivement $p_0$) mesurée dans un angle de la plaquette, à moins de 5 mm de chacun des deux côtés adjacents formant cet angle, et de préférence à moins de 1 mm de chacun des deux côtés. Ainsi, l'erreur de mesure due à l'hypothèse ci-dessus est minimale. De la même façon, lorsque les plaquettes ont une forme pseudo-carrée, la concentration en dopants donneurs $N_d$ (respectivement accepteurs $N_a$) est avantageusement obtenue à partir d'une valeur de la concentration $n_0$ (respectivement $p_0$) mesurée à proximité immédiate de l'un des angles tronqués de la plaquette, c'est-à-dire à moins de 5 mm de l'arrête formée par la troncature de l'angle, et de préférence à moins de 1 mm de cette arrête.

Il peut ensuite être fait l'hypothèse que la concentration en dopants accepteurs $N_A$ ou donneurs $N_D$ est constante sur toute la surface de la plaquette, ce qui permet de déterminer à l'étape S2 la concentration en donneurs thermiques [DT] dans n'importe quelle zone de la plaquette (connaissant la concentration en porteurs de charge libres $n_0/p_0$ dans cette zone).

Puis, en S3 (Fig.1), la durée de vie limitée par les donneurs thermiques $\tau_{DT}$ est calculée dans la zone de mesure des plaquettes, à partir de la concentration en donneurs thermiques [DT] déterminée à l'étape S2.

Comme indiqué précédemment, les donneurs thermiques limitent la durée de vie volumique des porteurs de charge en agissant comme centres de recombinaison indirecte des paires électron-trou. Le mécanisme de recombinaison des donneurs thermiques peut donc être décrit à l'aide du modèle de Shockley Read Hall (SRH). Selon ce modèle, la recombinaison d'une paire électron-trou se fait non pas par transition directe d'un électron de la bande de conduction vers la bande de valence, mais par l'intermédiaire d'un centre de recombinaison (ici une configuration de donneur thermique) qui introduit un niveau d'énergie dans la bande interdite du silicium.

D'après le modèle SRH, la durée de vie limitée par des centres de recombinaison SRH s'écrit de la façon suivante :

$$\tau_{SRH} = \frac{\dfrac{p_0 + p_1 + \Delta p}{\sigma_n . N_T . v_{th,e}} + \dfrac{n_0 + n_1 + \Delta p}{\sigma_p . N_T . v_{th,h}}}{p_0 + n_0 + \Delta p} \qquad (2)$$

où :

- $\sigma_n$ et $\sigma_p$ sont les sections de capture efficace des centres de recombinaison pour les électrons et les trous respectivement ;
- $v_{th,e}$ et $v_{th,h}$ sont les vitesses thermiques des électrons et des trous respectivement ;
- $N_T$ est la densité des centres de recombinaison ;
- $n_0$ et $p_0$ sont les concentrations en porteurs de charge à l'équilibre thermodynamique ;
- $n_1$ et $p_1$ sont les densités à l'équilibre en électrons et en trous respectivement, lorsque le niveau de Fermi coïncide avec le niveau d'énergie E introduit par les centres de recombinaison (soit $n_1 = N_C \exp\left(\dfrac{E - E_C}{kT}\right)$ et $p_1 = N_V \exp\left(\dfrac{E_V - E}{kT}\right)$ ); et
- $\Delta p$ est le niveau d'injection, c'est-à-dire la concentration en porteurs de charge excédentaires (i.e. hors équilibre thermodynamique).

L'étude de Tomassini et al. ([« Recombination activity associated with thermal donor generation in monocrystalline silicon and effect on the conversion efficiency of heterojunction solar cells », Journal of Applied Physics 119, 084508, 2016] a permis de déterminer que seuls les donneurs thermiques en configuration X agissaient comme centres de recombinaison SRH. Cette étude donne en outre les paramètres du modèle SRH dans le cas des donneurs thermiques (en configuration X), et plus particulièrement :

- la densité des centres de recombinaison (en cm$^{-3}$) :

$$N_T = 0{,}1268 \times [DT] + 3{,}956.10^{13}$$

- la position du niveau d'énergie associé aux donneurs thermiques en configuration X (en eV) :

$$E_C - E = 15{,}46 \times [DT]^{-0.12}$$

- la section efficace de capture des électrons et des trous (en cm$^2$) :

$$\sigma_n = 3{,}16.10^{-54} \times N_T^{2,41}$$

$$\sigma_p = 4{,}01.10^{-40} \times N_T^{1,53}$$

Tous ces paramètres dépendent de la concentration en donneurs thermiques [DT]. Ainsi, en les injectant dans le modèle SRH donné ci-dessus, on obtient une relation exprimant la durée de vie limitée par les donneurs thermiques ($\tau_{SRH} = \tau_{DT}$) en fonction de la concentration en donneurs thermiques [DT]. Cette relation est avantageusement utilisée à l'étape S3 pour déterminer la durée de vie limitée par les donneurs thermiques $\tau_{DT}$.

Puis, en S4, on calcule une valeur de durée de vie volumique $\tau_{bulk}$ des porteurs de charge dans la zone de mesure de chaque plaquette, à partir de la durée de vie limitée par les donneurs thermiques $\tau_{DT}$.

Il existe divers mécanismes de recombinaison qui limitent la durée de vie volumique des porteurs de charge dans le silicium : les recombinaisons radiatives et les recombinaisons via le mécanisme de Shockley Read Hall (recombinaisons SRH), précédemment mentionné et activé par exemple par les donneurs thermiques. Les mécanismes Auger et radiatif sont intrinsèques au matériau semi-conducteur, c'est-à-dire que leur amplitude ne dépend pas de la présence de défauts recombinants dans le matériau, à l'inverse du mécanisme SRH.

Dans certains cas, par exemple pour des niveaux d'injection faibles ($\Delta p < 10^{15}$ cm$^{-3}$), les mécanismes de recombinaison intrinsèques (Auger et radiatif) peuvent être négligés, car l'influence des donneurs thermiques sur la durée de vie volumique $\tau_{bulk}$ est prépondérante. La durée de vie volumique $\tau_{bulk}$ est alors égale à la durée de vie limitée par les donneurs thermiques $\tau_{DT}$.

Lorsqu'on estime, au contraire, que la durée de vie volumique des porteurs de charge n'est pas seulement limitée par les donneurs thermiques et que les recombinaisons de type Auger et/ou radiatives ne sont pas négligeables (cas des architectures de cellules solaires à haut rendement), le procédé de tri comporte avantageusement une étape de calcul de la durée de vie limitée par les mécanismes de recombinaison intrinsèques $\tau_{int}$. La durée de vie limitée par les mécanismes de recombinaison intrinsèques $\tau_{int}$ peut être calculée à partir de la concentration en porteurs de charge libres $n_0/p_0$, par exemple d'après la relation donnée dans l'article [« Improved quantitative description of Auger recombination in crystalline silicon », Richter et al., Physical Review B 86, 165202, 2012].

Le calcul de la durée de vie volumique $\tau_{bulk}$ est alors effectué à partir de la durée de vie limitée par les donneurs thermiques $\tau_{DT}$ et de la durée de vie limitée par les mécanismes de recombinaison intrinsèques $\tau_{int}$, d'après la relation suivante :

$$\tau_{bulk} = \frac{1}{\dfrac{1}{\tau_{DT}} + \dfrac{1}{\tau_{int}}} \qquad (4)$$

La valeur de durée de vie volumique $\tau_{bulk}$ ainsi calculée est plus précise et le tri des plaquettes effectué sur la base de cette valeur est plus rigoureux.

La valeur de durée de vie volumique $\tau_{bulk}$ calculée à l'étape S4 dans la zone de mesure à partir de la durée de vie limitée par les donneurs thermiques $\tau_{DT}$ et, de préférence à partir de la durée de vie limitée par les mécanismes de recombinaison intrinsèques $\tau_{int}$, est la meilleure (i.e. la plus élevée) valeur de durée vie volumique qu'on puisse atteindre dans cette zone, car des défauts de type SRH autres que les donneurs thermiques (impuretés métalliques, précipités d'oxygène...) n'ont pas été pris en compte. La durée de vie volumique réelle dans la zone sera vraisemblablement plus faible, en raison de ces défauts qu'on ne peut quantifier ou dont on ignore l'existence. Malgré tout, le tri effectué aura permis, déjà, d'éliminer une grande partie des plaquettes de mauvaise qualité.

Lorsqu'on possède des informations sur ces autres défauts agissant comme centre de recombinaison SRH, en particulier leur densité ($N_T$), leur section de capture (($\sigma_n$, $\sigma_p$), leur niveau d'énergie (E), il est préférable d'inclure leur contribution dans le calcul de la durée de vie volumique $\tau_{bulk}$. Cela permet d'avoir une estimation encore plus précise de la durée de vie volumique dans la plaquette. La durée de vie volumique est alors donnée par la relation suivante :

$$\frac{1}{\tau_{bulk}} = \frac{1}{\tau_{DT}} + \frac{1}{\tau_{int}} + \frac{1}{\tau_{SRH\,2}} + \frac{1}{\tau_{SRH\,3}} + \cdots$$

où $\tau_{SRH\,2}$ et $\tau_{SRH\,3}$ sont les durées de vie limitées par un deuxième et un troisième type de défauts recombinants, calculées à l'aide du modèle SRH.

La durée de vie limitée par les donneurs thermiques $\tau_{DT}$, la durée de vie limitée par les mécanismes de recombinaison intrinsèques $\tau_{int}$, ainsi que les éventuelles durées de vie $\tau_{SRH\,2}$, $\tau_{SRH\,3}$ (et donc la durée de vie volumique $\tau_{bulk}$) sont avantageusement calculées à un niveau d'injection donné, choisi par l'utilisateur en fonction de l'utilisation des plaquettes. Pour la fabrication de cellules photovoltaïques, on pourra choisir un niveau d'injection compris entre $10^{14}$ cm$^{-3}$ et $10^{16}$ cm$^{-3}$, et de préférence égal à $10^{15}$ cm$^{-3}$.

L'étape S5 de la figure 1 consiste à comparer la valeur de durée de vie volumique $\tau_{bulk}$ obtenue à l'étape S4 à une valeur seuil de durée de vie, notée ci-après $\tau_{lim}$. Lorsque la valeur de durée de vie volumique $\tau_{bulk}$ d'une plaquette est supérieure au seuil $\tau_{lim}$ (sortie « NON » en S5), cela signifie que la qualité de la plaquette est satisfaisante. La plaquette peut donc être conservée. À l'inverse, lorsque la valeur de durée de vie volumique $\tau_{bulk}$ est inférieure au seuil $\tau_{lim}$ (sortie « OUI » en S5), la plaquette est considérée comme étant de mauvaise qualité. Elle est alors écartée lors d'une étape finale S6 du procédé de tri.

La zone de la plaquette, dans laquelle est mesurée (à l'étape S1) la concentration en porteurs de charge libres (« zone de mesure ») et dont on calcule la durée de vie volumique (au moyen des étapes S2 à S4), est avantageusement éloignée des bords de la plaquette d'une distance supérieure à 5 mm. En effet, la concentration en donneurs thermiques à la périphérie de la plaquette (sur une bande de 5 mm de largeur) n'est pas suffisamment élevée pour aboutir à un tri satisfaisant des plaquettes de silicium (pour mémoire, elle est même considérée comme nulle aux fins de la détermination de la concentration en dopants $N_a/N_d$).

Les étapes S1 à S4 du procédé de tri sont de préférence mises en œuvre dans la zone centrale de la plaquette. Ceci permet de trier efficacement les plaquettes de silicium tout en minimisant le nombre de mesures. En effet, d'après l'article susmentionné de J. Broisch et al., la concentration en donneurs thermiques [DT] d'une plaquette en silicium Cz est maximale dans une zone située au centre de la plaquette et diminue progressivement en s'éloignant du centre de la plaquette (pour atteindre une concentration quasiment nulle au niveau des bords). C'est par conséquent au centre de la plaquette qu'on s'attend à rencontrer la valeur de durée de vie volumique la plus faible. Un procédé de tri de plaquettes limité à une seule zone éloignée du centre de la plaquette sera moins précis et par conséquent moins efficace.

Dans un souci de précision, au cas où la plus faible valeur de durée de vie volumique ne se situerait pas au centre de la plaquette, les étapes S1 à S4 du procédé de tri peuvent être mises en œuvre dans plusieurs zones d'une même plaquette, de préférence en incluant la zone centrale. Cela permet d'obtenir plusieurs valeurs de durée de vie volumique $\tau_{bulk}$ pour une même plaquette. Dans ce cas, le procédé de tri comporte avantageusement une étape consistant à déterminer, parmi ces différentes valeurs de durée de vie volumique $\tau_{bulk}$, celle qui est la plus faible, autrement dit la plus contraignante pour effectuer le tri. La comparaison de l'étape S5 est alors effectuée entre la valeur seuil $\tau_{lim}$ et cette valeur minimale de durée de vie volumique $\tau_{bulk}$.

D'une manière générale, la reproduction des étapes S1 à S4 en différentes zones de mesure de la plaquette améliore la qualité du tri de plaquettes. En multipliant les mesures, la valeur de durée de vie volumique extraite et comparée à la valeur seuil $\tau_{lim}$ lors de l'étape S5 a plus de chance d'être représentative de la (véritable) valeur minimale de durée de vie volumique $\tau_{bulk}$ de la plaquette. L'écartement des plaquettes de mauvaise qualité sera donc plus juste. En contrepartie, le procédé de tri peut être plus long à exécuter car le nombre de mesures et de calculs est plus important. Le nombre et la localisation de ces zones de mesure peuvent différer d'une plaquette à l'autre.

La valeur seuil $\tau_{lim}$ est de préférence fixée en fonction des performances des cellules photovoltaïques attendues par les fabricants, compte tenu du procédé utilisé pour fabriquer ces cellules. Elle peut être déterminée de manière empirique par chaque fabricant de cellules photovoltaïques, en comparant la durée de vie des plaquettes et le rendement des cellules finies pour un échantillon de plaquettes. Elle peut également être obtenue par le biais de simulations des performances cellule, ces simulations prenant en compte l'architecture des cellules.

Par exemple, pour un procédé optimisé de fabrication de cellules à hétérojonction en silicium (amorphe/cristallin) (HET) dont le rendement théorique maximal est de 24,5 %, une valeur seuil $\tau_{lim}$ égale à 3 ms (pour un niveau d'injection $\Delta p$ de $1.10^{15}$ cm$^{-3}$) permettrait d'obtenir un rendement d'au moins 23,5% avec toutes les plaquettes issues du tri. Pour un procédé de fabrication pouvant encore être amélioré, permettant d'obtenir au maximum un rendement théorique d'environ 21,6%, une valeur seuil $\tau_{lim}$ autour de 1 ms permettrait d'atteindre un rendement d'au moins 20,6% avec toutes les plaquettes triées.

La valeur seuil $\tau_{lim}$ peut également être fixée en tenant compte de la concentration en dopants accepteurs ou donneurs des plaquettes. En effet, en fixant une valeur seuil $\tau_{lim}$ trop contraignante, c'est-à-dire très élevée, on risque d'écarter des plaquettes dont la faible durée de vie volumique serait due à une variation brusque du dopage dans la zone de mesure, et non à une concentration élevée en donneurs thermiques. On estime que la concentration en dopants peut varier entre le bord et le centre de la plaquette d'au maximum 30 %. La concentration en donneurs thermiques [DT], à partir de laquelle il est possible d'écarter une plaquette, devrait donc être supérieure à 15% de $N_a$ ou $N_d$. Autrement dit, il est possible de fixer la valeur seuil $\tau_{lim}$ à la valeur de durée de vie volumique calculée pour une concentration [DT] égale à 15% de $N_a$ ou $N_d$.

À titre d'exemple, pour des plaquettes dopées au phosphore avec une concentration en dopants [P] égale à $2,4.10^{15}$ cm$^{-3}$ (2 Ω.cm) et une concentration en donneurs thermiques [DT] inférieure à $3,75.10^{14}$ cm$^{-3}$, il est difficile de différencier l'influence des donneurs thermiques sur le dopage net de la variation naturelle de la concentration en dopants [P]. Pour permettre de réaliser un tri qui prenne bien en compte les donneurs thermiques, la valeur seuil $\tau_{lim}$ devrait donc être inférieure à 8,2 ms (valeur obtenue avec les relations (2) à (4) ci-dessus en prenant [DT] = $3,75.10^{14}$ cm$^{-3}$ et un niveau d'injection de $10^{15}$ cm$^{-3}$).

Un tri peut également être effectué sur la base d'une valeur normalisée de la durée de vie volumique. On comparera alors à l'étape S5 cette valeur normalisée de la durée de vie volumique à un autre seuil (de mêmes unités), plutôt que comparer deux valeurs de durées de vie (en s). De préférence, la valeur de la durée de vie volumique est normalisée par rapport à la résistivité électrique. La valeur normalisée de la durée de vie volumique est obtenue en divisant la valeur de durée de vie volumique $\tau_{bulk}$ calculée à l'étape S4 par la résistivité $\rho$ ($\tau_{bulk}/\rho$). En effet, la résistivité influence grandement la durée de vie et il est plus facile d'atteindre des fortes durées de vie lorsque la résistivité est grande.

Les étapes de calcul S2-S4 et de comparaison à la valeur seuil S5 peuvent être mises en œuvre par une unité de calcul, telle qu'un microprocesseur.

Dans un mode de mise en œuvre préférentiel du procédé de tri, la concentration en porteurs de charge libres $n_0/p_0$ est mesurée à l'étape S1 par photoluminescence (PL). La photoluminescence est une technique répandue pour caractériser un matériau semi-conducteur. Elle repose sur l'excitation du matériau semi-conducteur par une source lumineuse afin de générer des porteurs de charge libres et sur la détection optique des recombinaisons radiatives de ces porteurs. L'intensité $I_{PL}$ du signal de photoluminescence obtenu dans la zone de mesure de la plaquette s'exprime (à faible niveau d'injection) par la relation suivante :

$$I_{PL} \propto n_0\, G\, \tau_{eff}$$

dans le silicium type n ;

$$I_{PL} \propto p_0\, G\, \tau_{eff}$$

dans le silicium type p ;
où $\tau_{eff}$ est la durée de vie effective des porteurs de charge photogénérés et $G$ le taux de génération de porteurs de charge.

Dans une plaquette brute de découpe dont l'épaisseur est faible, typiquement inférieure à 580 μm, la durée de vie effective des porteurs de charge $\tau_{eff}$ est essentiellement limitée par les recombinaisons en surface. En effet, la passivation des défauts présents en surface de la plaquette n'ayant pas encore eu lieu, la grande majorité des porteurs de charge photogénérés se recombinent en surface. La durée de vie effective des porteurs de charge $\tau_{eff}$ est donc sensiblement égale à la durée de vie des porteurs de charge limitée par les recombinaisons en surface $\tau_{surf}$. Par ailleurs, comme les plaquettes brutes de découpe ont une épaisseur sensiblement uniforme, le taux de génération G et la durée de vie surfacique des porteurs de charge $\tau_{surf}$ peuvent être supposés constants. L'intensité $I_{PL}$ du signal de photoluminescence est donc proportionnelle à la concentration en porteurs de charge libres $n_0/p_0$ :

$$I_{PL} \propto n_0$$

dans le silicium type n ; et

$$I_{PL} \propto p_0$$

dans le silicium type p.

Ainsi, en extrayant la valeur du signal de photoluminescence dans une zone de la plaquette, il est possible d'en déduire la concentration en porteurs de charge libres $n_0/p_0$ dans cette même zone.

Le facteur de proportionnalité entre l'intensité $I_{PL}$ et la concentration $n_0/p_0$ dépend, entre autres, de l'équipement utilisé pour la mesure de photoluminescence. Une étape préalable de calibration peut donc être mise en œuvre afin de déterminer ce facteur de proportionnalité. L'étape de calibration peut consister en une série de mesures de photoluminescence à l'aide de l'équipement à calibrer, sur des plaquettes « échantillon » en silicium dont on connait la concentration en porteurs de charge libres. Les plaquettes échantillon ont de préférence les mêmes caractéristiques morphologiques (épaisseur, état de surface) que les plaquettes à trier, en particulier une épaisseur inférieure à 580 μm. La concentration en porteurs de charge libres des plaquettes échantillon peut être mesurée par une technique autre que la photoluminescence, par exemple par une mesure de la résistivité électrique.

Les conditions d'acquisition du signal de photoluminescence, lors de l'étape de calibration puis lors de l'étape S1 de mesure de la concentration en porteurs de charge libres no/po, peuvent être les suivantes :

- la source d'excitation (typiquement un laser) illumine les plaquettes en silicium à une longueur d'onde inférieure à 1100 nm, et de préférence inférieure à 915 nm, afin de générer des paires électron-trou dans la bande interdite du silicium :
- la durée d'illumination est inférieure ou égale à 30 s, et de préférence inférieure à 1 s, afin d'être compatible avec la cadence d'une ligne de production de cellules photovoltaïques ;
- la puissance de la source d'excitation est comprise entre 0,01 W/cm² et 1 W/cm² ;
- la détection de la photoluminescence est effectuée (en imagerie) à l'aide d'un photodétecteur dont la résolution spatiale est inférieure à 5 mm (dimensions des pixels : 5 mm x 5 mm), et de préférence inférieure à 1 mm (1 mm x 1 mm).

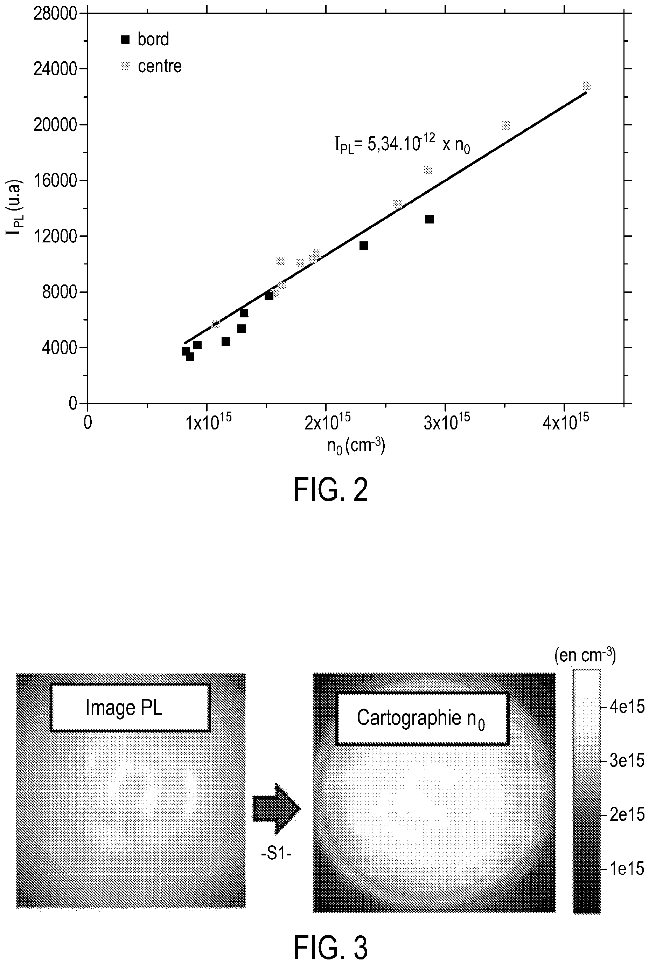

La figure 2 est une représentation graphique des mesures faites lors de la calibration d'un équipement de photoluminescence, par exemple le modèle « LIS-R2 » commercialisé par la société « BT-Imaging ». Ce graphique représente l'intensité $I_{PL}$ du signal de photoluminescence mesurée en différentes zones des plaquettes échantillon (toutes de type n), en fonction de la concentration en porteurs de charge libres majoritaires ($n_0$) dans ces mêmes zones. Les zones de mesure sont ici au nombre de deux, l'une au centre de la plaquette, l'autre près d'un bord de la plaquette.

Le facteur de proportionnalité entre l'intensité $I_{PL}$ et la concentration en porteurs de charge libres majoritaires $n_0/p_0$ est déterminé par régression linéaire des points de mesure. Il est dans cet exemple de calibration égal à $5,34.10^{-12}$ coups.cm$^3$.

Les équipements de photoluminescence actuels permettent d'acquérir rapidement une image complète de chaque plaquette. Ainsi, grâce à cette technique, il est possible de d'obtenir la concentration en porteurs de charge libres $n_0/p_0$ dans un grand nombre de zones de mesure simultanément.

Grâce au facteur de proportionnalité, une image de photoluminescence (PL) peut être convertie à l'étape S2 du procédé de tri en une cartographie de la concentration en porteurs de charge libres majoritaires $n_0/p_0$. Ce mode de mise en œuvre préférentiel de l'étape S2 est représenté schématiquement par la figure 3.

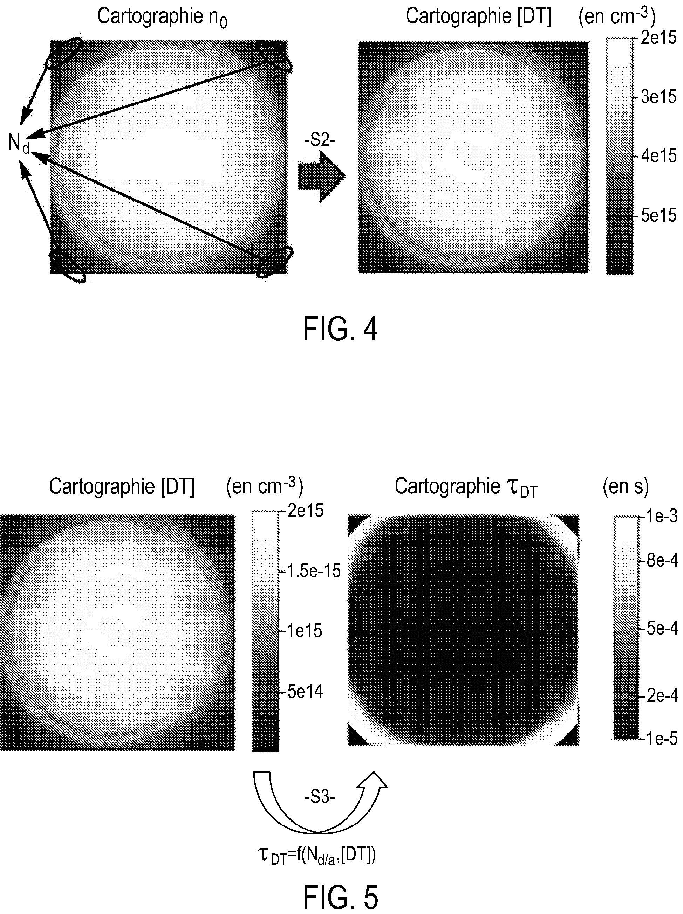

On peut ensuite extraire de la cartographie en $n_0/p_0$ la valeur de la concentration en dopants accepteurs $N_a$ ou donneurs $N_d$ au sein de la plaquette, par exemple grâce aux valeurs de $n_0/p_0$ mesurées aux angles de la plaquette. La photoluminescence permet, contrairement à d'autres techniques (notamment la mesure de résistivité électrique) d'accéder à la concentration $n_0/p_0$ au plus près des bords de la plaquette. Puis, la cartographie de la concentration en porteurs de charge $n_0/p_0$ est convertie en une cartographie de la concentration en donneurs thermiques [DT] à l'étape S3 du procédé de tri. Ces deux opérations sont représentées schématiquement par la figure 4.

Enfin, comme cela est représenté sur la figure 5, la cartographie de la concentration en donneurs thermiques [DT] peut être convertie en une cartographie de la durée de vie limitée par les donneurs thermiques $\tau_{DT}$ lors de l'étape S3.

Le premier procédé de tri décrit ci-dessus en référence aux figures 1 à 5 est applicable aussi bien aux plaquettes de silicium dopées de type n (électrons majoritaires) qu'aux plaquettes de silicium dopées de type p (trous majoritaires). Le nombre et la nature des éléments chimiques servant de dopants dans les plaquettes (bore, phosphore, arsenic, antimoine...) n'a aucune influence sur le tri. Le procédé pourrait même être appliqué à des plaquettes dopées uniquement avec des donneurs thermiques (donc nécessairement de type n), c'est-à-dire des plaquettes issues d'un lingot dans lequel aucun dopant n'a été introduit volontairement.

Dans de rares cas, la quantité de donneurs thermiques dans une plaquette dopée de type p peut être, localement, tellement importante qu'il existe un changement du type de conductivité au sein même de la plaquette. Typiquement, les bords de la plaquette sont dopés de type p, tandis que le centre de la plaquette, riche en donneurs thermiques, deviendrait dopé de type n. Cette situation dite d'inversion du dopage peut notamment se produire lorsque la plaquette est extraite de la partie haute du lingot. Une plaquette qui présente une inversion du type de dopage (i.e. du type p au type n) ne sera pas nécessairement écartée par le procédé de tri de la figure 1. Elle aboutira pourtant à une cellule photovoltaïque très peu performante, voire à une cellule photovoltaïque inopérante.

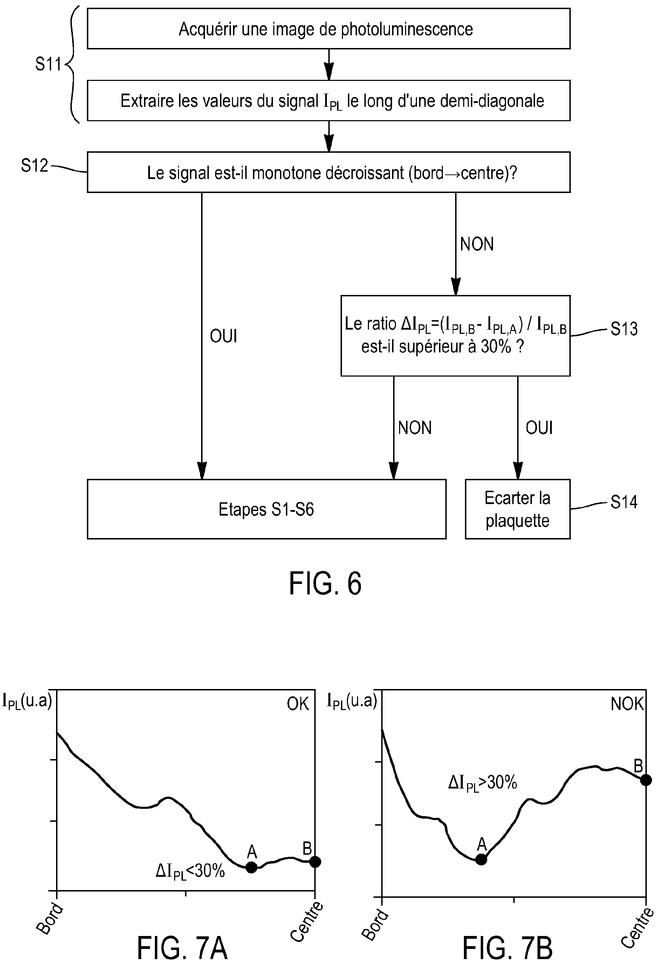

La figure 6 représente des étapes S11 à S14 d'un deuxième procédé de tri, dérivé du premier procédé décrit en relation avec la figure 1, pour identifier et écarter ce type de plaquettes.

Ce deuxième procédé de tri débute par une étape S11 pendant laquelle on effectue des mesures d'un paramètre représentatif de la concentration en porteurs de charge libres majoritaires $n_0/p_0$ dans chaque plaquette à trier. Les points de mesure sont répartis entre un bord et le centre de la plaquette et, de préférence, alignés le long d'une demi-diagonale ou d'un rayon de la plaquette.

Le paramètre représentatif de la concentration en porteurs de charge libres majoritaires peut être le signal d'un équipement de caractérisation, qui varie en fonction de la concentration en porteurs de charge libres majoritaires, par exemple la résistivité électrique ou la réflectivité aux micro-ondes. Par définition, l'expression « paramètre représentatif de la concentration en porteurs de charge libres majoritaires » peut faire référence à la concentration en porteurs de charge libres majoritaires en elle-même.

Dans le mode de mise en œuvre préférentiel de l'étape S11 représenté sur la figure 6, le paramètre représentatif de la concentration en porteurs de charge libres majoritaires $n_0/p_0$ est l'intensité de photoluminescence $I_{PL}$. L'étape S11 consiste alors à acquérir une image de photoluminescence de chaque plaquette, puis à extraire de cette image des valeurs d'intensité de photoluminescence réparties entre le bord et le centre de la plaquette. À partir de ces valeurs, il est ensuite possible de tracer une courbe représentant la variation du signal $I_{PL}$ depuis le bord jusqu'au centre de la plaquette.

On vérifie ensuite, au cours d'une étape S12, si l'intensité de photoluminescence $I_{PL}$ diminue de façon continue entre le bord et le centre de la plaquette, c'est-à-dire si la courbe de l'intensité $I_{PL}$ décroît de façon monotone.

Si l'intensité de photoluminescence $I_{PL}$ diminue de façon continue entre le bord et le centre de la plaquette (sortie « OUI » en S13), cela signifie qu'il n'y a pas d'inversion du type de dopage dans la plaquette. Cette diminution du signal $I_{PL}$ est représentative d'une diminution (continue) de la concentration en trous, vraisemblablement causée par une augmentation (également continue) de la concentration en donneurs thermiques. Les étapes S1 à S6 décrites précédemment en relation avec la figure 1 sont alors mises en œuvre (en réutilisant avantageusement les valeurs du signal $I_{PL}$ à l'étape S1) pour vérifier si la qualité de la plaquette, en termes de durée de vie volumique, est satisfaisante.

Si par contre l'intensité de photoluminescence $I_{PL}$ ne diminue pas de façon continue (sortie « NON » en S12), c'est-à-dire si elle connait une augmentation entre le bord et le centre de la plaquette comme cela est représenté sur les figures 7A et 7B, des étapes supplémentaires sont mises en œuvre pour déterminer si l'augmentation de l'intensité $I_{PL}$ est simplement due à une augmentation, locale et de faible amplitude, de la concentration en dopants accepteurs $N_a$ (et/ou une diminution locale de la concentration en donneurs thermiques) ou à une inversion du type de dopage causée par une forte concentration en donneurs thermiques.

Ainsi, lors d'une étape S13, on détermine la variation radiale relative de l'intensité de photoluminescence entre le minimum de l'intensité $I_{PL}$ (dans l'exemple des figures 7A-7B, il s'agit du point « A ») et l'intensité $I_{PL}$ mesurée au centre de la plaquette (point « B »).

La variation radiale relative $\Delta I_{PL}$ de l'intensité de photoluminescence entre le point A (minimum de l'intensité) et le point B (point central) s'écrit de la façon suivante :

$$\Delta I_{PL} = \frac{I_{PL,B} - I_{PL,A}}{I_{PL,B}}$$

où $I_{PL,A}$ et $I_{PL,B}$ sont les valeurs de l'intensité de photoluminescence $I_{PL}$ aux points A et B respectivement.

La variation radiale relative $\Delta I_{PL}$ de l'intensité de photoluminescence est ensuite comparée à une valeur seuil, par exemple 30 %. La valeur seuil est choisie de manière à exclure des variations de l'intensité de photoluminescence qui seraient causées par des variations naturelles du dopage. Dans le silicium CZ de type p, les variations relatives de la concentration en dopants accepteurs ne dépassent généralement pas 30 %.

Si la variation radiale relative $\Delta I_{PL}$ de l'intensité de photoluminescence est inférieure au seuil de 30 % (sortie « NON » en S13), la plaquette présente une augmentation locale de la concentration en dopants accepteurs $N_A$, voire une diminution locale de la concentration en donneurs thermiques [DT], mais pas une inversion du type de dopage. La plaquette n'est alors pas nécessairement de mauvaise qualité. Les étapes S1 à S6 du procédé de la figure 1 sont mises en œuvre pour vérifier sa compatibilité, en termes de durée de vie volumique, avec le procédé de fabrication des cellules. Si par contre la variation radiale relative $\Delta I_{PL}$ est supérieure à 30 % (sortie « OUI » en S13), cela signifie que la plaquette présente une inversion du dopage. Cette plaquette est alors écartée lors d'une étape S14.

Les deux procédés de tri qui viennent d'être décrits en relation avec les figures 1 et 6 s'avèrent particulièrement avantageux dans le cadre de la fabrication de cellules photovoltaïques à hétérojonction, pour écarter les plaquettes qui mèneront à des rendements trop faibles, et plus particulièrement les plaquettes provenant du haut du lingot.

Bien que les cellules photovoltaïques à homojonction soient insensibles aux donneurs thermiques, les procédés de tri peuvent également être utilisés en entrée d'une ligne de production de cellules à homojonction. En effet, une concentration élevée en donneurs thermiques dans les plaquettes de silicium à l'état brut de découpe révèle souvent la présence d'autres défauts, comme des précipités d'oxygène, qui limiteront la durée de vie volumique des porteurs de charge dans les cellules finies. Ainsi, en écartant une plaquette de durée de vie limitée par les donneurs thermiques trop faible, conformément aux procédés de tri selon l'invention, on écarte très certainement une plaquette dont la durée de vie volumique sera limitée par ces autres défauts. Enfin, contrairement au procédé de tri de l'art antérieur, les procédés de tri selon l'invention ne requièrent pas d'accomplir la première étape du procédé de fabrication des cellules à homojonction (diffusion de l'émetteur). Ils sont donc plus simples et plus économiques à mettre en œuvre.

Lorsque les plaquettes à trier sont destinées à la fabrication de cellules photovoltaïques à homojonction, la durée de vie volumique calculée à l'étape S4 ne correspond pas à la véritable durée de vie des cellules photovoltaïques à homojonction, puisque les donneurs thermiques auront disparu entre-temps. Cela ne remet toutefois pas en cause l'intérêt et l'efficacité du tri des plaquettes.

De nombreuses variantes et modifications des procédés de tri selon l'invention apparaîtront à l'homme du métier. En particulier, il est possible de considérer à l'étape S2 une distribution inhomogène des dopants, plutôt que de prendre une concentration en dopants $N_a$ ou $N_d$ constante sur la plaquette. Par exemple, une variation linéaire de la concentration en dopants $N_a$ ou $N_d$ entre le bord et le centre de la plaquette peut être introduite. Cela aura pour effet d'améliorer la précision de calcul de la concentration en donneurs thermiques [DT].

Par ailleurs, la technique de photoluminescence peut être utilisée sans toutefois acquérir une image complète de chaque plaquette. En effet, dans un mode de mise en œuvre du procédé de tri, un seul point de mesure peut suffire (préférentiellement au centre). Les mesures s'effectueront alors point par point, avec un spot laser millimétrique.

Les procédés de tri peuvent également être appliqués à des plaquettes qui, après avoir été livrées dans l'état brut de découpe, ont été soumises à une étape de mise en forme de la surface, telle qu'une étape de texturation ou une étape de polissage mécanique et/ou chimique.

Quel que soit leur état (brut de découpe ou avec une surface mise en forme), les plaquettes à trier sont exemptes de couche de passivation et n'ont subi aucun traitement à une température supérieure ou égale à 350°C, et de préférence aucune étape de passivation.

**EP 3 510 640 B1**

**Revendications**

1. Procédé de tri de plaquettes obtenues par découpage d'un lingot en silicium monocristallin de type Czochralski, le procédé étant mis en œuvre lorsque les plaquettes sont dans un état brut de découpe ou dans un état de mise en forme de leur surface et comprenant les étapes suivantes :

   a) mesurer (S1) la concentration en porteurs de charge libres majoritaires (no, po) dans une zone au moins de chaque plaquette ;
   b) calculer (S2) la concentration en donneurs thermiques ([DT]) dans ladite zone de chaque plaquette, à partir de la concentration en porteurs de charge libres majoritaires ($n_0$, $p_0$) ;
   c) calculer (S3) la durée de vie des porteurs de charge limitée par les donneurs thermiques ($\tau_{DT}$) dans ladite zone de chaque plaquette, à partir de la concentration en donneurs thermiques ([DT]) ;
   d) déterminer (S4) une valeur de durée de vie volumique ($\tau_{bulk}$) des porteurs de charge dans chaque plaquette, à partir de la durée de vie limitée par les donneurs thermiques ($\tau_{DT}$) ;
   e) comparer (S5) la valeur de durée de vie volumique ($\tau_{bulk}$) ou une valeur normalisée de la durée de vie volumique à une valeur seuil ($\tau_{lim}$) ; et
   f) écarter (S6) la plaquette lorsque la valeur de durée de vie volumique ($\tau_{eff}$) ou la valeur normalisée de la durée de vie volumique est inférieure à la valeur seuil ($\tau_{lim}$).

2. Procédé selon la revendication 1, dans lequel ladite zone de chaque plaquette est éloignée des bords de la plaquette d'une distance supérieure à 5 mm.

3. Procédé selon l'une des revendications 1 et 2, dans lequel ladite zone de chaque plaquette est située au centre de la plaquette.

4. Procédé selon l'une quelconque des revendications 1 à 3, comprenant en outre une étape de calcul de la durée de vie des porteurs de charge limitée par des mécanismes de recombinaison intrinsèques ($\tau_{int}$) dans ladite zone de chaque plaquette, la valeur de durée de vie volumique ($\tau_{bulk}$) étant en outre déterminée à partir de la durée de vie limitée par les mécanismes de recombinaison intrinsèques ($\tau_{int}$).

5. Procédé selon l'une des revendications 1 à 4, dans lequel la concentration en porteurs de charge libres ($n_0$, $p_0$) dans ladite zone est obtenue à partir d'une mesure de photoluminescence de la plaquette.

6. Procédé selon la revendication 5, dans lequel l'épaisseur des plaquettes est inférieure à 580 $\mu$m.

7. Procédé selon l'une quelconque des revendications 1 à 6, dans lequel les étapes a) à d) sont mises en œuvre dans plusieurs zones de chaque plaquette, d'où il résulte une pluralité de valeurs de durée de vie volumique pour chaque plaquette, le procédé comprenant en outre une étape de détermination, parmi la pluralité de valeurs de durée de vie volumique, d'une valeur minimale de durée de vie, ladite valeur minimale étant comparée à la valeur seuil à l'étape e).

8. Procédé selon l'une quelconque des revendications 1 à 7, comportant en outre, lorsque les plaquettes contiennent des dopants, une étape de mesure de la concentration en dopants ($N_d$, $N_a$) de chaque plaquette, la concentration en donneurs thermiques ([DT]) dans ladite zone de chaque plaquette étant calculée à l'étape b) à partir de la concentration en porteurs de charge libres majoritaires ($n_0$, $p_0$) et de la concentration en dopants ($N_d$, $N_a$).

9. Procédé selon la revendication 8, dans lequel la concentration en dopants ($N_d$, $N_a$) de chaque plaquette est obtenue par une mesure de la concentration en porteurs de charge libres majoritaires ($n_0$, $p_0$) dans une zone située au voisinage immédiat d'un bord de la plaquette.

10. Procédé selon la revendication 9, dans lequel la concentration en porteurs de charge libres majoritaires ($n_0$, $p_0$) dans la zone située au voisinage immédiat du bord de la plaquette est dérivée d'une mesure de photoluminescence.

11. Procédé selon l'une quelconque des revendications 1 à 10, dans lequel les plaquettes sont dopées de type n.

12. Procédé selon l'une quelconque des revendications 1 à 11, dans lequel la valeur normalisée de la durée de vie volumique est calculée à partir de la valeur de durée de vie volumique ($\tau_{bulk}$) obtenue à l'étape d) et d'une valeur de résistivité de la plaquette.

13

**13.** Procédé de tri de plaquettes obtenues par découpage d'un lingot en silicium monocristallin de type Czochralski contenant des dopants de type p, le procédé étant mis en œuvre lorsque les plaquettes sont dans un état brut de découpe ou dans un état de mise en forme de leur surface et comprenant les étapes suivantes :

- effectuer des mesures d'un paramètre représentatif de la concentration en porteurs de charge libres majoritaires $(n_0/p_0)$ sur chaque plaquette, les mesures étant réparties entre un bord et le centre de la plaquette ;
- déterminer si ledit paramètre diminue de façon continue entre le bord et le centre de chaque plaquette ; et

lorsque ledit paramètre diminue de façon continue, les étapes suivantes :

a) mesurer (S1) la concentration en porteurs de charge libres majoritaires (no, po) dans une zone au moins de la plaquette ;
b) calculer (S2) la concentration en donneurs thermiques ([DT]) dans ladite zone de la plaquette, à partir de la concentration en porteurs de charge libres majoritaires $(n_0, p_0)$ ;
c) calculer (S3) la durée de vie des porteurs de charge limitée par les donneurs thermiques $(\tau_{DT})$ dans ladite zone de la plaquette, à partir de la concentration en donneurs thermiques ([DT]) ;
d) déterminer (S4) une valeur de durée de vie volumique $(\tau_{bulk})$ des porteurs de charge dans la plaquette, à partir de la durée de vie limitée par les donneurs thermiques $(\tau_{DT})$ ;
e) comparer (S5) la valeur de durée de vie volumique $(\tau_{bulk})$ à une première valeur seuil $(\tau_{lim})$ ;
f) écarter (S6) la plaquette lorsque la valeur de durée de vie volumique $(\tau_{eff})$ est inférieure à la première valeur seuil $(\tau_{lim})$ ; et

lorsque ledit paramètre ne diminue pas de façon continue, les étapes suivantes :

- déterminer une variation relative $(\Delta I_{PL})$ dudit paramètre entre le minimum (A) dudit paramètre et une valeur dudit paramètre au centre (B) de la plaquette ;
- comparer la variation relative $(\Delta I_{PL})$ dudit paramètre à une deuxième valeur seuil ;
- écarter la plaquette lorsque la deuxième variation relative $(\Delta I_{PL})$ dudit paramètre est supérieure à la deuxième valeur seuil ;
- mettre en œuvre les étapes a) à f) lorsque la variation relative $(\Delta I_{PL})$ dudit paramètre est inférieure à la deuxième valeur seuil.

**Patentansprüche**

**1.** Verfahren zum Sortieren von Wafern, die per Ausschneiden aus einem monokristallinen Siliziumblock vom Typ Czochralski erhalten werden, wobei das Verfahren umgesetzt wird, wenn die Wafer in einem Rohzustand des Ausschnitts oder in einem geformten Zustand ihrer Oberfläche sind und die folgenden zwei Schritte umfassen:

a) Messen (S1) der Konzentration von Trägern von mehrheitlichen freien Chargen (no/po) in einem Bereich (Z1) von wenigstens jedem Wafer;
b) Berechnen (S2) der Konzentration an thermischen Spendern ([DT]) in dem genannten Bereich jedes Wafers aus der Konzentration an mehrheitlichen freien Chargen $(n_0/p_0)$;
c) Berechnen (S3) der Lebensdauer der Chargenträger, die durch die thermischen Spender $(\tau_{DT})$ begrenzt wird, in dem genannten Bereich jedes Wafers aus der Konzentration an thermischen Spendern ([DT]);
d) Bestimmen (S4) eines Wertes der Volumen-Lebensdauer $(\tau_{bulk})$ der Chargenträger in jedem Wafer aus der von den thermischen Spendern begrenzten Lebensdauer $(T_{DT})$;
e) Vergleichen (S5) des Volumenwertes der Lebensdauer $(\tau_{bulk})$ oder eines normalisierten Wertes der Volumen-Lebensdauer mit einem Schwellenwert $(\tau_{lim})$; und
f) Aussortieren (S6) des Wafers, wenn der Wert der Volumen-Lebensdauer $(\tau_{eff})$ oder der normalisierte Wert der Volumen-Lebensdauer unter dem Schwellenwert $(\tau_{lim})$ liegt.

**2.** Verfahren gemäß Anspruch 1, bei dem der genannte Bereich jedes Wafers von den Rändern des Wafers um eine Entfernung von mehr als 5 mm entfernt ist.

**3.** Verfahren gemäß einem der Ansprüche 1 und 2, bei dem der genannte Bereich jedes Wafers im Zentrum des Wafers angeordnet wird.

**4.** Verfahren gemäß irgendeinem der Ansprüche 1 bis 3, umfassend darüber hinaus einen Berechnungsschritt der Lebensdauer der Chargenträger, die durch intrinsische Rekombinationsmechanismen ($\tau_{int}$) begrenzt ist, in dem genannten Bereich jedes Wafers, wobei der Wert der Volumen-Lebensdauer ($\tau_{bulk}$) darüber hinaus aus der Lebensdauer bestimmt wird, die von den intrinsischen Rekombationsmechanismen ($\tau_{int}$) begrenzt wird.

**5.** Verfahren gemäß einem der Ansprüche 1 bis 4, bei dem die Konzentration an freien Chargenträgern ($n_0/p_0$) in dem genannten Bereich aus einer Messung der Fotolumineszenz der Platte erhalten wird.

**6.** Verfahren gemäß Anspruch 5, bei dem die Dicke der Wafer geringer ist als 580 $\mu$m.

**7.** Verfahren gemäß irgendeinem der Ansprüche 1 bis 6, bei dem die Schritte a) bis d) in mehreren Bereichen jedes Wafers umgesetzt werden, woraus eine Vielzahl von Werten mit einer Volumen-Lebensdauer für jeden Wafer resultiert, wobei das Verfahren darüber hinaus einen Bestimmungsschritt eines Mindestwertes der Lebensdauer aus der Vielzahl von Werten der Volumen-Lebensdauer umfasst, wobei der genannte Mindestwert mit dem Schwellenwert des Schritts e) verglichen wird.

**8.** Verfahren gemäß irgendeinem der Ansprüche 1 bis 7, umfassend darüber hinaus einen Messchritt der Konzentration an Dotanten ($N_d$, $N_a$) jedes Wafers, wenn die Wafer Dotanten enthalten, wobei die Konzentration an thermischen Spendern ([DT]) in dem genannten Bereich jedes Wafers im Schritt b) aus der Konzentration an Trägern von mehrheitlichen freien Chargen ($n_0/p_0$) und der Konzentration an Dotanten ($N_d$, $N_a$) berechnet wird.

**9.** Verfahren gemäß Anspruch 8, bei dem die Konzentration an Dotanten ($N_d$, $N_a$) jedes Wafers durch eine Messung der Konzentration an Trägern von mehrheitlichen freien Chargen ($n_0/p_0$) in einem Bereich erhalten wird, der in der unmittelbaren Nachbarschaft eines Randes des Wafers erhalten wird.

**10.** Verfahren gemäß Anspruch 9, bei dem die Konzentration an Trägern von mehrheitlichen freien Chargen ($n_0/p_0$) in dem Bereich, der in der unmittelbaren Nachbarschaft des Randes des Wafers angeordnet ist, aus einer Messung der Fotolumineszenz abgeleitet wird.

**11.** Verfahren gemäß irgendeinem der Ansprüche 1 bis 10, bei dem die Wafer vom Typ n dotiert sind.

**12.** Verfahren gemäß irgendeinem der Ansprüche 1 bis 11, bei dem der normalisierte Wert der Volumen-Lebensdauer aus dem Wert der Volumen-Lebensdauer ($\tau_{bulk}$) berechnet wird, der aus dem Schritt d) und einem Resistivitätswert des Wafers erhalten wird.

**13.** Verfahren zum Sortieren von Wafern, die per Ausschneiden aus einem monokristallinen Siliziumblock vom Typ Czochralski erhalten werden, die Dotanten vom Typ p enthalten, wobei das Verfahren umgesetzt wird, wenn die Wafer in einem Rohzustand des Ausschnitts oder in einem geformten Zustand ihrer Oberfläche sind und die folgenden zwei Schritte umfassen

- Durchführen der Messungen eines Parameters, der die Konzentration an Trägern von mehrheitlichen freien Chargen (no/po) darstellt, auf jedem Wafer, wobei die Messungen zwischen einem Rand und dem Zentrum des Wafers verteilt sind;
- Bestimmen, ob der genannte Parameter zwischen dem Rand und dem Zentrum jedes Wafers kontinuierlich abnimmt; und

wenn der genannte Parameter kontinuierlich abnimmt, die folgenden Schritte:

a) Messen (S1) der Konzentration von Trägern von mehrheitlichen freien Chargen (no/po) in einem Bereich von wenigstens dem Wafer;
b) Berechnen (S2) der Konzentration an thermischen Spendern ([DT]) in dem genannten Bereich des Wafers aus der Konzentration an mehrheitlichen freien Chargen ($n_0/p_0$);
c) Berechnen (S3) der Lebensdauer der Chargenträger, die durch die thermischen Spender ($\tau_{DT}$) begrenzt wird, in dem genannten Bereich des Wafers aus der Konzentration an thermischen Spendern ([DT]);
d) Bestimmen (S4) eines Wertes der Volumen-Lebensdauer ($\tau_{bulk}$) der Chargenträger in dem Wafer aus der von den thermischen Spendern begrenzten Lebensdauer ($T_{DT}$);
e) Vergleichen (S5) des Wertes der Volumen-Lebensdauer ($\tau_{bulk}$) mit einem Schwellenwert ($\tau_{lim}$);
f) Aussortieren (S6) des Wafers, wenn der Wert der Volumen-Lebensdauer ($\tau_{eff}$) unter dem ersten Schwellenwert

**15**

($\tau_{lim}$) liegt; und

wenn der genannte Parameter nicht kontinuierlich abnimmt, die folgenden Schritte:

- Bestimmen einer relativen Abweichung ($\Delta I_{PL}$) des genannten Parameters zwischen dem Minimum (A) des genannten Parameters und einem Wert des genannten Parameters im Zentrum (B) des Wafers;
- Vergleichen der relativen Abweichung ($\Delta I_{PL}$) des genannten Parameters mit einem zweiten Schwellenwert; und
- Aussortieren des Wafers, wenn die zweite relative Abweichung ($\Delta I_{PL}$) des genannten Parameters größer ist als der zweite Schwellenwert;
- Umsetzen der Schritte a) bis f), wenn die relative Abweichung ($\Delta I_{PL}$) des genannten Parameters kleiner ist als der zweite Schwellenwert.

**Claims**

1. Method for sorting wafers obtained by cutting a Czochralski-type monocrystalline silicon ingot, the method being carried out when the wafers are in an as-cut state or in a surface-shaped state and comprising the following steps:

   a) measuring (S1) the majority free charge carrier concentration ($n_0$, $p_0$) in at least one area of each wafer;
   b) calculating (S2) the thermal donor concentration ([DT]) in said area of each wafer from the majority free charge carrier concentration ($n_0$, $p_0$);
   c) calculating (S3) the thermal donors-limited lifetime ($\tau_{DT}$) of the charge carriers in said area of each wafer, from the thermal donor concentration ([DT]);
   d) determining (S4) a bulk lifetime value ($\tau_{bulk}$) of the charge carriers in each wafer, from the thermal donors-limited lifetime ($\tau_{DT}$);
   e) comparing (S5) the bulk lifetime value ($\tau_{bulk}$) or a normalised value of the bulk lifetime with a threshold value ($\tau_{lim}$); and
   f) discarding (S6) the wafer when the bulk lifetime value ($\tau_{eff}$) or the normalised value of the bulk lifetime is lower than a threshold value ($\tau_{lim}$).

2. Method according to claim 1, wherein said area of each wafer is over 5 mm from the edges of the wafer.

3. Method according to one of claims 1 and 2, wherein said area of each wafer is in the centre of the wafer.

4. Method according to any one of claims 1 to 3, further comprising a step of calculating the charge carrier lifetime limited by intrinsic recombination mechanisms ($\tau_{int}$) in said area of each wafer, the bulk lifetime value ($\tau_{bulk}$) being further determined from the lifetime limited by the intrinsic recombination mechanisms ($\tau_{int}$).

5. Method according to one of claims 1 to 4, wherein the free charge carrier concentration ($n_0$, $p_0$) in said area is obtained from a measurement of photoluminescence of the wafer.

6. Method according to claim 5, wherein the thickness of the wafers is less than 580 $\mu$m.

7. Method according to any one of claims 1 to 6, wherein steps a) to d) are carried out in several areas of each wafer, resulting in a plurality of bulk lifetime values for each wafer, the method further comprising a step of determining, from the plurality of bulk lifetime values, a minimum lifetime value, said minimum value being compared with the threshold value in step e).

8. Method according to any one of claims 1 to 7, further comprising, when the wafers contain dopants, a step of measuring the dopant concentration ($N_d$, $N_a$) of each wafer, the thermal donor concentration ([DT]) in said area of each wafer being calculated in step b) from the majority free charge carrier concentration ($n_0$, $p_0$) and from the dopant concentration ($N_d$, $N_a$).

9. Method according to claim 8, wherein the dopant concentration ($N_d$, $N_a$) of each wafer is obtained by measuring the majority free charge carrier concentration ($n_0$, $p_0$) in an area in the immediate vicinity of an edge of the wafer.

10. Method according to claim 9, wherein the majority free charge carrier concentration ($n_0$, $p_0$) in the area in the immediate vicinity of the edge of the wafer is derived from a measurement of photoluminescence.

**11.** Method according to any one of claims 1 to 10, wherein the wafers are n-type doped.

**12.** Method according to any one of claims 1 to 11, wherein the normalised bulk lifetime value is calculated from the bulk lifetime value ($\tau_{bulk}$) obtained in step d) and from a resistivity value of the wafer.

**13.** Method for sorting wafers obtained by cutting a Czochralski-type monocrystalline silicon ingot containing p-type dopants, the method being carried out when the wafers are in an as-cut state or in a surface-shaped state and comprising the following steps:

- making measurements of a parameter representing the majority free charge carrier concentration ($n_0/p_0$) in each wafer, the measurements being distributed between an edge and the centre of the wafer;
- determining whether said parameter decreases continuously between the edge and centre of each wafer; and

when said parameter decreases continuously, the following steps:

a) measuring (S1) the majority free charge carrier concentration ($n_0$, $p_0$) in at least one area of the wafer;
b) calculating (S2) the thermal donor concentration ([DT]) in said area of the wafer from the majority free charge carrier concentration ($n_0$, $p_0$);
c) calculating (S3) the thermal donors-limited lifetime ($\tau_{DT}$) of the charge carriers in said area of the wafer, from the thermal donor concentration ([DT]);
d) determining (S4) a bulk lifetime value ($\tau_{bulk}$) of the charge carriers in the wafer, from the thermal donors-limited lifetime ($\tau_{DT}$);
e) comparing (S5) the bulk lifetime value ($\tau_{bulk}$) with a first threshold value ($\tau_{lim}$);
f) discarding (S6) the wafer when the bulk lifetime value ($\tau_{eff}$) is lower than the first threshold value ($\tau_{lim}$); and

when said parameter does not decrease continuously, the following steps:

- determining a relative variation ($\Delta I_{PL}$) of said parameter between the minimum (A) of said parameter and a value of said parameter in the centre (B) of the wafer;
- comparing the relative variation ($\Delta I_{PL}$) of said parameter with a second threshold value;
- discarding the wafer when the second relative variation ($\Delta I_{PL}$) of said parameter is higher than the second threshold value;
- carrying out steps a) to f) when the relative variation ($\Delta I_{PL}$) of said parameter is less than the second threshold value.

S1 — $n_0(ou\ p_0)$

$\downarrow$

S2 — $n_0(ou\ p_0) => [DT]$

$\downarrow$

S3 — $[DT] => \tau_{DT}$

$\downarrow$

S4 — $\tau_{DT} => \tau_{bulk}$

$\downarrow$

S5 — $\tau_{bulk} < \tau_{lim}\ ?$ ——— NON

OUI

S6 — Ecarter la plaquette          Conserver la plaquette

FIG. 1

FIG. 2

FIG. 3

Cartographie $n_0$

Cartographie [DT]   (en cm$^{-3}$)

$N_d$

-S2-

2e15
3e15
4e15
5e15

## FIG. 4

Cartographie [DT]   (en cm$^{-3}$)

Cartographie $\tau_{DT}$   (en s)

2e15
1.5e-15
1e15
5e14

1e-3
8e-4
5e-4
2e-4
1e-5

-S3-

$\tau_{DT} = f(N_{d/a}, [DT])$

## FIG. 5

S11 {
Acquérir une image de photoluminescence

Extraire les valeurs du signal $I_{PL}$ le long d'une demi-diagonale
}

S12 — Le signal est-il monotone décroissant (bord→centre)?

NON

Le ratio $\Delta I_{PL}=(I_{PL,B}- I_{PL,A}) / I_{PL,B}$ est-il supérieur à 30% ? — S13

OUI

NON          OUI

Etapes S1-S6

Ecarter la plaquette — S14

## FIG. 6

$I_{PL}$(u.a)                    OK

A    B

$\Delta I_{PL}<30\%$

Bord                          Centre

## FIG. 7A

$I_{PL}$(u.a)                    NOK

B

$\Delta I_{PL}>30\%$

A

Bord                          Centre

## FIG. 7B

## RÉFÉRENCES CITÉES DANS LA DESCRIPTION

**Documents brevets cités dans la description**

- FR 2964459

**Littérature non-brevet citée dans la description**

- Quality Control of Czochralski Grown Silicon Wafers in Solar Cell Production Using Photoluminescence Imaging. **J. HAUNSCHILD et al.** 26th European PV Solar Energy Conférence and Exhibition. Hamburg, 05 Septembre 2011
- **J. BROISCH et al.** A New Method for the Détermination of the Dopant-Related Base Resistivity Despite the Presence of Thermal Donors. *IEEE Journal of Photovoltaics,* 2015, vol. 5 (1
- **TOMASSINI et al.** Recombination activity associated with thermal donor generation in monocrystalline silicon and effect on the conversion efficiency of heterojunction solar cells. *Journal of Applied Physics,* 2016, vol. 119, 084508
- **RICHTER et al.** Improved quantitative description of Auger recombination in crystalline silicon. *Physical Review B,* 2012, vol. 86, 165202